# EUROPEAN PATENT SPECIFICATION

(11) **EP 4 398 295 B1**
(45) Date of publication and mention of the grant of the patent: **03.09.2025**
(21) Application number: 21964438.2
(22) Date of filing: 19.11.2021
(51) Int. Cl.: H01L 23/485, H01L 23/498, H01L 23/538, H01L 25/065, H01L 23/532, H01L 23/00, H05K 1/18, H05K 3/46

(54) **PACKAGING STRUCTURE AND PREPARATION METHOD THEREFOR, PACKAGING MODULE, AND ELECTRONIC DEVICE**
VERPACKUNGSSTRUKTUR UND HERSTELLUNGSVERFAHREN DAFÜR, VERPACKUNGSMODUL UND ELEKTRONISCHE VORRICHTUNG
STRUCTURE D'ENCAPSULATION ET SON PROCÉDÉ DE PRÉPARATION, MODULE D'ENCAPSULATION ET DISPOSITIF ÉLECTRONIQUE

(43) Date of publication of application: 10.07.2024
(73) Proprietor: Huawei Technologies Co., Ltd., Shenzhen, Guangdong 518129 (CN)
(72) Inventor: TONG, Liang, Shenzhen, Guangdong 518129 (CN); ZHANG, Shan, Shenzhen, Guangdong 518129 (CN); SUN, Shihu, Shenzhen, Guangdong 518129 (CN); LIU, Guowen, Shenzhen, Guangdong 518129 (CN)
(74) Representative: Maiwald GmbH
(86) International application number: PCT/CN2021/131935
(87) International publication number: WO 2023/087284

(56) References cited:
- CN-A- 112 188 731
- US-A1- 2009 085 192
- US-A1- 2015 270 247
- US-A1- 2018 269 146
- US-A1- 2019 013 288
- US-A1- 2019 131 242
- US-A1- 2019 312 009
- US-A1- 2020 168 518
- US-A1- 2020 203 279
- US-A1- 2020 350 254
- US-A1- 2021 257 324

## Description

### TECHNICAL FIELD

This application relates to the field of semiconductor packaging technologies, and in particular, to a package structure and a preparation method thereof, a package module, and an electronic device.

### BACKGROUND

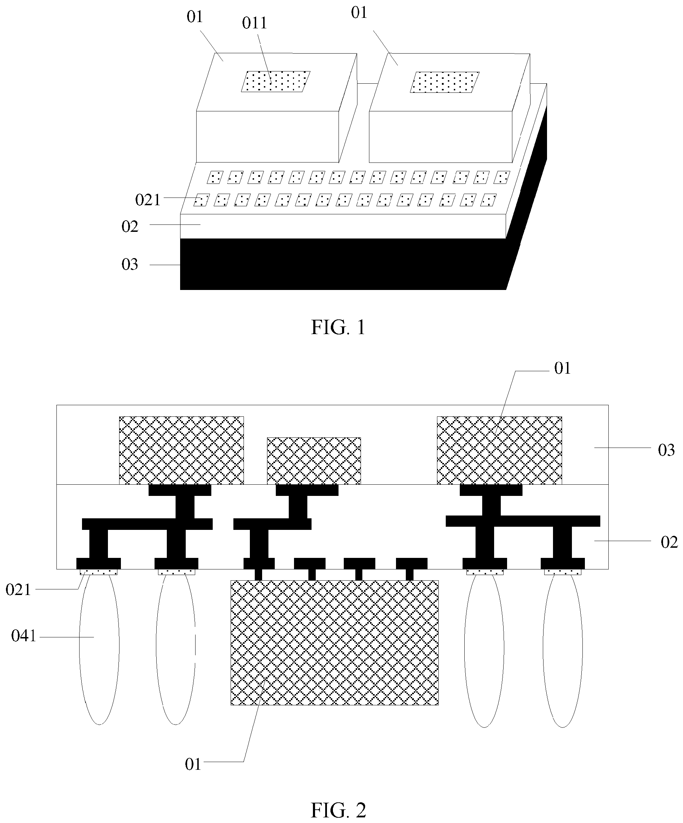

With development of communication technologies, there are increasing requirements for a power supply circuit that supplies power to a communication apparatus. To implement power conversion with high efficiency, a printed circuit board (printed circuit board, PCB) of the power supply circuit includes a large quantity of electronic components. However, a use environment of the power supply circuit is increasingly severe. For example, the power supply circuit is required to occupy a smaller board area, but have stronger anti-corrosion and anti-radiation capabilities. To reduce the board area occupied by the power supply circuit, in other words, to reduce an area of the PCB, as shown in FIG. 1, various electronic components 01 are generally packaged on a front and a back of a package substrate 02 separately, and then are mounted on the PCB (not shown in FIG. 1). In FIG. 1, electronic components located on the front of the package substrate 02 are already plastically packaged by a plastic packaging material 03. However, such a packaging manner causes a height difference between different conductive connection pads (pads) on the back of the package substrate 02. For example, a height difference exists between a conductive connection pad 021 on the package substrate 02 and a conductive connection pad 011 on the electronic component 01.

To resolve a problem of the height difference between different conductive connection pads, as shown in FIG. 2, a solder ball (solder ball) 041 is usually disposed on the conductive connection pad 021 of the package substrate 02. However, because the solder ball 041 is in a liquid state during high-temperature reflow (reflow) soldering, a maximum height is low due to tension, and generally does not exceed 300 µm. As a result, the problem of the large height difference cannot be resolved.

United States patent application US 2020/0203279 A1 describes a semiconductor package including a frame having first and second surfaces opposite to each other, having first and second through holes, and including a wiring structure connecting the first and second surfaces, a connection structure disposed on the first surface of the frame and having a redistribution layer connected to the wiring structure.

United States patent application US 2019/0312009 A1 describes an integrated circuit chip carrier including one or more memory devices.

United States patent application US 2020/0350254 A1 describes a conductive structure including a core portion, a plurality of electronic devices and a filling material, wherein the core portion defines a cavity, the electronic devices are disposed in the cavity of the core portion and the filling material is disposed between the electronic devices and a sidewall of the cavity of the core portion.

United States patent application US 2015/0270247 A1 describes a semiconductor package including a first package with one or more dies and a redistribution layer coupled to the one or more dies at a first side of the first package with a first set of bonding joints.

United States patent application US 2021/0257324 A1 describes a semiconductor package including a redistribution layer and a semiconductor chip provided on the redistribution layer having a first surface and a second surface opposite to the first surface.

### SUMMARY

This application provides a package structure and a preparation method thereof, a package module, and an electronic device, to resolve a problem of a height difference between different conductive connection pads on a package substrate.

The invention is set out in the appended set of claims.

According to a first aspect, this application provides a package structure. The package structure is mounted on a back of a package substrate, and is then mounted on a circuit board. The package structure includes a frame plate, a first electronic component, a filling material, and a plurality of conductive connection pads. The frame plate may be made of any dielectric material suitable for forming the frame plate. This is not limited herein. The frame plate has a first surface and a second surface that are opposite and parallel to each other, the frame plate includes a through hole, and the frame plate has a hollowed-out region. A quantity of the hollowed-out region and a quantity of the through hole are not limited in this application, and may be specifically designed based on an actual product. Both the filling material and the first electronic component are located in the hollowed-out region, and the first electronic component is fastened in the hollowed-out region by using the filling material. In other words, the first electronic component and the frame plate are packaged together by using the filling material. A quantity of the first electronic component in the hollowed-out region is not limited in this application, and may be specifically designed based on an actual product. The plurality of conductive connection pads may include: a first conductive connection pad located on the first surface and electrically connected to the through hole, a second conductive connection pad located on the second surface and electrically connected to the through hole, and a third conductive connection pad located on the first surface and electrically connected to the first electronic component, and a fourth conductive connection pad located on the second surface and electrically connected to the first electronic component. A quantity of the third conductive connection pad and a quantity of the fourth conductive connection pad are not limited in this application, and are specifically determined based on a structure of the first electronic component.

In this application, both the first conductive connection pad and the third conductive connection pad are located on the first surface, and both the second conductive connection pad and the fourth conductive connection pad are located on the second surface. In this way, on one side of the first surface, a surface of the third conductive connection pad and a surface of the first conductive connection pad may be caused to be in a same plane, so that a height of the conductive connection pad of the first electronic component, that is, the third conductive connection pad, is consistent with a height of the first conductive connection pad. On one side of the second surface, a surface of the fourth conductive connection pad and a surface of the second conductive connection pad may be in a same plane, so that a height of the conductive connection pad of the first electronic component, that is, the fourth conductive connection pad, is consistent with a height of the second conductive connection pad.

In actual application, generally, an electronic component is plastically packaged on a front of the package substrate, and a conductive connection pad of the electronic component on the front of the package substrate is led out through a conductive connection pad disposed on the back of the package substrate. When the package structure provided in this embodiment of this application is mounted on the back of the package substrate, the first electronic component in the package substrate may be packaged on the back of the package substrate, and the through hole in the package structure may also be used to lead out the conductive connection pad on the back of the package substrate, to resolve a problem of a height difference between the conductive connection pad on the back of the package substrate and the conductive connection pad of the first electronic component. In addition, because both the through hole and the first electronic component are packaged in the frame plate, that is, the package structure is a structure in which the through hole and the first electronic component are formed into a same module, the conductive connection pads electrically connected to the through hole and the conductive connection pads electrically connected to the first electronic component may be formed on a same surface. In this way, a height difference between the conductive connection pads located on the same surface may be controlled to be within 20 µm, to reduce a risk of mounting the package structure and the circuit board. In addition, in this application, both the through hole and the first electronic component are packaged in the frame plate, and a thickness of the frame plate may be designed based on a height of the first electronic component. Therefore, a problem of a large height difference between the conductive connection pad on the package substrate and the conductive connection pad on the electronic component can be resolved. In addition, in this application, a plurality of first electronic components may be packaged in the package structure and may be mounted on the back of the package substrate through one mounting process, so that a quantity of times of mounting can be reduced, to improve production efficiency and reduce product processing costs. In addition, the package structure provided in this embodiment of this application may be compatible with a conventional device and a conventional manufacturing process, the manufacturing process is simple, and a yield rate is high.

It should be noted that, in this embodiment of this application, the concept of "being in a same plane" does not mean being in a same plane in a strict sense. In a process of preparing the package structure, due to impact of a preparation process and a preparation device, there may be a case in which the surfaces are not strictly in a same plane. This case is caused by a specific preparation procedure, and it cannot be indicated that the case in which the surfaces are not strictly in the same plane goes beyond the protection scope of this application. In addition, a similar understanding is also provided for a location relationship of "parallel", and details are not described herein again.

During specific implementation, in this application, for surfaces that are of different conductive connection pads and that are in a same plane, a height difference within a range of 20 µm is allowed.

For example, the first electronic component may be a component such as an integrated chip, a switch element, a resistor, a capacitor, or a magnetic core. The integrated chip may be a voltage conversion chip, a transformer chip, or the like. This is not limited herein.

During specific implementation, the thickness of the frame plate may be designed based on the height of the first electronic component. In this application, heights of the first electronic components located in the hollowed-out region are basically the same.

For example, in the package structure provided in this application, the package structure provided in this application further includes a second electronic component. The plurality of conductive connection pads further include a fifth conductive connection pad located on the first surface and connected to the second electronic component. The second electronic component is fastened in the hollowed-out region by using the filling material. That is, a gap that exists after the first electronic component and the second electronic component are placed in the hollowed-out region is filled with the filling material. In this application, the first electronic component and the second electronic component are packaged in a same package structure. In this way, the first electronic component and the second electronic component may be mounted on the back of the package substrate through one mounting process, so that the quantity of times of mounting can be reduced, to improve the production efficiency and reduce the product processing costs.

For example, the second electronic component may be a component such as an integrated chip, a switch element, a resistor, a capacitor, or a magnetic core. The integrated chip may be a voltage conversion chip, a transformer chip, or the like. This is not limited herein.

It should be noted that, in this application, a main difference between the first electronic component and the second electronic component lies in that both sides of the first electronic component have a conductive connection pad, and only one side of the second electronic component has the conductive connection pad. For example, in actual application, the first electronic component needs to be electrically connected to both the package substrate and a PCB, and in actual application, the second electronic component only needs to be electrically connected to the package substrate or the PCB. During specific implementation, a height of the second electronic component is generally less than or equal to the height of the first electronic component. The conductive connection pad is disposed on one side that is of the second electronic component and that is close to the first surface, and on one side of the second surface, the filling material covers the second electronic component.

During specific implementation, to implement electrical connection between the conductive connection pads on both sides of the through hole, the through hole may be filled with the conductive material. However, when the thickness of the frame plate is thick, a process of fully filling the through hole with a conductive material is difficult. For example, the conductive material may be formed on a side wall of the through hole, and then a region defined by the conductive material is filled with a resin material.

For example, the conductive material may be a metal material, for example, gold, silver, aluminum, zinc, copper, chromium, nickel, or palladium. The resin material may be a material such as epoxy resin. This is not limited herein.

The frame plate includes at least two dielectric material plates disposed in a stacked manner. Each one of the dielectric material plates has vias, and one through hole may include one via in each dielectric material plate. A routing layer is further disposed between any two adjacent dielectric material plates, and vias in the any two adjacent dielectric material plates are electrically connected through the routing layer. That is, locations of vias belonging to a same through hole may be different, and different vias are electrically connected through the routing layer. In this way, the package structure may have a possibility of re-routing, so that locations of the first conductive connection pad and the second conductive connection pad may be flexibly set, to reduce a trace pressure of the package substrate.

The routing layer includes at least one conductive layer and an insulation medium layer, and a circuit trace is disposed on the conductive layer. When the routing layer includes two or more conductive layers, the insulation medium layer is provided with a medium through hole to connect circuit traces on different conductive layers.

Optionally, in the package structure, a metal trace may be disposed on a side wall of the hollowed-out region of the frame plate, and the metal trace may extend from one side of the first surface to one side of the second surface through the side wall of the hollowed-out region. The plurality of conductive connection pads may further include: a sixth conductive connection pad located on the first surface and electrically connected to the metal trace, and a seventh conductive connection pad located on the second surface and electrically connected to the metal trace. That is, the metal trace is used to replace the through hole, so that the quantity of the through hole in the package structure can be reduced.

A quantity of the metal trace is not limited in this application, and is specifically designed based on an actual product. When there are a plurality of metal traces, the metal traces may be disposed at intervals, to ensure that different metal traces are insulated from each other.

For example, the metal trace may be made of a material such as gold, silver, aluminum, zinc, copper, chromium, nickel, or palladium. This is not limited herein.

Optionally, in this application, the package structure may further include an interconnection line layer. The interconnection line layer is located on the second surface of the frame plate. Both the second conductive connection pad and the fourth conductive connection pad are located on the interconnection line layer. The second conductive connection pad is electrically connected to the through hole through the interconnection line layer, and the fourth conductive connection pad is electrically connected to the first electronic component through the interconnection line layer. In this way, the interconnection line layer is used, so that locations of the second conductive connection pad and the fourth conductive connection pad may be re-arranged.

According to a second aspect, this application further provides a package module, including a package substrate and a package structure according to the first aspect or the implementations of the first aspect that is mounted on the package substrate.

During specific implementation, the package substrate may be any structure on which a line is disposed, such as a re-routing layer, a substrate, or a silicon interposer. This is not limited herein.

For example, the package structure may be mounted on the package substrate by using technologies such as surface mounting.

In an embodiment, the package structure may be mounted on a back of the package substrate, an electronic component is generally disposed on a front of the package substrate, and a conductive connection pad of the electronic component on the front of the package substrate is led out through a conductive connection pad disposed on the back of the package substrate.

Certainly, during specific implementation, the package structure may alternatively be mounted on the front of the package substrate, or both sides of the package structure are provided with the package substrate. This is not limited herein, and may be designed according to an actual requirement.

Further, in this application, when the package structure is mounted on the package substrate, one side of a first surface of a frame plate in the package structure may be disposed facing the package substrate, or one side of a second surface of the frame plate in the package structure may be disposed facing the package substrate. This is not limited herein, and may be designed according to an actual requirement.

For example, in this application, when the package structure is mounted on the back of the package substrate, one side of the first surface of the frame plate in the package structure may be disposed facing the package substrate. In this way, the package structure may not only package a first electronic component on the back of the package substrate, but may also use a through hole in the package structure to lead out the conductive connection pad on the back of the package substrate, to resolve a problem of a height difference between the conductive connection pad on the back of the package substrate and a conductive connection pad of the first electronic component.

According to a third aspect, this application further provides an electronic device, including a housing, a circuit board located in the housing, and the package module according to the implementations of the second aspect. The package module is located on the circuit board, and the package module is electrically connected to the circuit board. For example, the circuit board is a PCB. A problem-resolving principle of the electronic device is similar to that of the foregoing package module. Therefore, for the implementation of the electronic device, refer to the implementation of the foregoing package module, and details are not described again.

According to a fourth aspect, this application further provides a preparation method of a package structure. The method includes the following steps: step S101: forming a first conductive connection pad on a first surface of a frame plate; step S102: forming a through hole in a region that is of the frame plate and that corresponds to the first conductive connection pad; step S103: forming a hollowed-out region in the frame plate; step S104: causing the first surface of the frame plate to face downward, placing a first electronic component in the hollowed-out region, where the first electronic component has a third conductive connection pad, and causing a surface of the third conductive connection pad and a surface of the first conductive connection pad to be in a same plane; step S105: filling a gap of the hollowed-out region with a filling material; step S106: grinding a second surface of the frame plate, where the second surface is opposite and parallel to the first surface; and step S107: forming, on the second surface, a fourth conductive connection pad electrically connected to the first electronic component, and a second conductive connection pad electrically connected to the through hole.

In this application, each electronic component is packaged in the hollowed-out region of the frame plate, and when the electronic component is placed in the hollowed-out region, a conductive connection pad that is of the electronic component and that is located on one side of the first surface and the first conductive connection pad connected to the through hole are in a same plane. In addition, after each electronic component is packaged in the hollowed-out region of the frame plate, the second surface of the frame plate is ground, so that the conductive connection pad connected to the electronic component and the second conductive connection pad connected to the through hole are formed on the same plane of the frame plate. Therefore, a height difference between the conductive connection pads that are of the package structure and that are in the same plane is controlled to be within 20 µm.

Optionally, before the placing a first electronic component in the hollowed-out region, the method may further include: placing the frame plate on which the first conductive connection pad and the through hole are formed on a peelable mask; and peeling off the peelable mask after the fourth conductive connection pad electrically connected to the first electronic component and the second conductive connection pad electrically connected to the through hole are formed on the second surface.

For example, a material of the peelable mask is an ultraviolet photoinduced peelable mask, and the peelable mask may be peeled off through exposure to ultraviolet light.

For example, the forming a through hole in a region that is of the frame plate and that corresponds to the first conductive connection pad may include: making a hole in the region that is of the frame plate and that corresponds to the first conductive connection pad; plating a side wall of the hole with a conductive material; and filling, with a resin material, the hole plated with the conductive material.

Optionally, the frame plate may include a first dielectric material plate, a second dielectric material plate, and a routing layer. The forming a first conductive connection pad on a first surface of a frame plate, and the forming a through hole in a region that is of the frame plate and that corresponds to the first conductive connection pad include: forming the first conductive connection pad on a surface of one side of the first dielectric material plate; forming a first via in a region that is of the first dielectric material plate and that corresponds to the first conductive connection pad; forming the routing layer on one side that is of the first dielectric material plate and that is away from the first conductive connection pad, where the routing layer is electrically connected to the first via of the first dielectric material plate; forming the second dielectric material plate on one side that is of the routing layer and that is away from the first dielectric material plate; and forming a second via in the second dielectric material plate, where the routing layer is electrically connected to the second via of the second dielectric material plate.

For example, after the forming a hollowed-out region in the frame plate, and before the filling a gap of the hollowed-out region with a filling material, the method further includes: placing a second electronic component in the hollowed-out region, where the second electronic component has a fifth conductive connection pad, and causing a surface of the fifth conductive connection pad of the second electronic component and a surface of the first conductive connection pad to be in a same plane.

Optionally, in this application, when the first conductive connection pad is formed on the first surface of the frame plate, the method may further include: forming a sixth conductive connection pad on the first surface of the frame plate; after the forming a hollowed-out region in the frame plate, and before the placing a first electronic component in the hollowed-out region, the method further includes: forming a metal trace on a side wall of the hollowed-out region, where the metal trace is electrically connected to the sixth conductive connection pad; and when the fourth conductive connection pad electrically connected to the first electronic component, and the second conductive connection pad electrically connected to the through hole are formed on the second surface, the method further includes: forming, on the second surface, a seventh conductive connection pad electrically connected to the metal trace. That is, the metal trace is used to replace the through hole, so that the quantity of the through hole in the package structure can be reduced. For example, the metal trace may be formed through electroplating. This is not limited herein.

For technical effect that can be achieved in the second aspect to the fourth aspect, refer to the descriptions of technical effect that can be achieved by any possible design in the foregoing first aspect. Details are not described herein again.

### BRIEF DESCRIPTION OF DRAWINGS

FIG. 1 is a schematic diagram of a partial structure of an existing power supply circuit;
FIG. 2 is a schematic diagram of a partial structure of a power supply circuit according to the conventional technology;
FIG. 3 is a schematic diagram of a structure of an electronic device according to an embodiment of this application;
FIG. 4 is a schematic diagram of a cross-sectional structure of a package structure according to an embodiment of this application;
FIG. 5 is a schematic diagram of an application scenario of a package structure according to an embodiment of this application;
FIG. 6 is a schematic diagram of a cross-sectional structure of another package structure according to an embodiment of this application;
FIG. 7 is a schematic diagram of a cross-sectional structure of another package structure according to an embodiment of this application;
FIG. 8 is a schematic diagram of a cross-sectional structure of another package structure according to an embodiment of this application;
FIG. 9 is a schematic diagram of a cross-sectional structure of another package structure according to an embodiment of this application;
FIG. 10 is a schematic flowchart of a preparation method of a package structure according to an embodiment of this application;
FIG. 11a to FIG. 11k are schematic diagrams of a structure of a process of preparing a package structure according to an embodiment of this application;
FIG. 12a to FIG. 12e are schematic diagrams of a partial structure of a process of preparing another package structure according to an embodiment of this application; and
FIG. 13 is a schematic diagram of a cross-sectional structure of a package module according to an embodiment of this application.

### Descriptions of reference numerals:

1: housing; 2: circuit board;
3: package module; 10: package structure;
20: package substrate; 110: frame plate;
110a: first surface; 110b: second surface;
001: first conductive connection pad; 002: second conductive connection pad;
003: third conductive connection pad; 004: fourth conductive connection pad;
005: fifth conductive connection pad; 111: conductive material;
120: filling material; 121: first electronic component;
122: second electronic component; 1101: first dielectric material plate;
1102: second dielectric material plate; 1103: routing layer;
210: interconnection line layer; V1: through hole;
V2: hollowed-out region; 310: peelable mask;
21: electronic component on a front of a package substrate;
22: conductive connection pad on a back of a package substrate;
L1: thickness of a frame plate;
H1: height of a first electronic component;
H2: height of a second electronic component;
1131: conductive layer of a routing layer;
1132: insulation medium layer of a routing layer;
211: conductive layer of an interconnection line layer; and
212: insulation medium layer of an interconnection line layer.

### DESCRIPTION OF EMBODIMENTS

To make objectives, technical solutions, and advantages of this application clearer, the following further describes this application in detail with reference to the accompanying drawings.

Terms used in the following embodiments are merely intended to describe specific embodiments, but are not intended to limit this application. As used in this specification and appended claims of this application, singular expressions "one", "a", "the ", "the foregoing", "this", and "the one" are intended to also include expressions such as "one or more", unless the contrary is clearly indicated in the context.

In descriptions of this application, it should be noted that an orientation or a location relationship indicated by the terms "middle", "above", "below", "left", "right", "vertical", "horizontal", "inner", "outer", and the like is an orientation or a location relationship based on the accompanying drawings, and is merely intended for ease of describing this application and simplifying descriptions, but does not indicate or imply that a specified apparatus or element needs to have a specific orientation or needs to be constructed and operated in a specific orientation. Therefore, such terms cannot be understood as a limitation on this application. Expressions of locations and directions described in this application are all described by using the accompanying drawings as an example. However, changes may also be made as required, and all the changes fall within the protection scope of the present invention. The accompanying drawings in this application are merely used to illustrate relative location relationships and do not represent an actual scale. In addition, terms "first" and "second" are merely used for a purpose of description, and cannot be understood as an indication or implication of relative importance.

In descriptions of this application, it should be noted that unless otherwise expressly specified and limited, terms "mount", "connected", and "connection" should be understood in a broad sense. For example, such terms may indicate a fixed connection, a detachable connection, or an integrated connection; may indicate a mechanical connection or an electrical connection; or may indicate a direct connection, an indirect connection through an intermediate medium, or an internal connection between two elements. A person of ordinary skill in the art may understand specific meanings of the foregoing terms in this application based on specific cases.

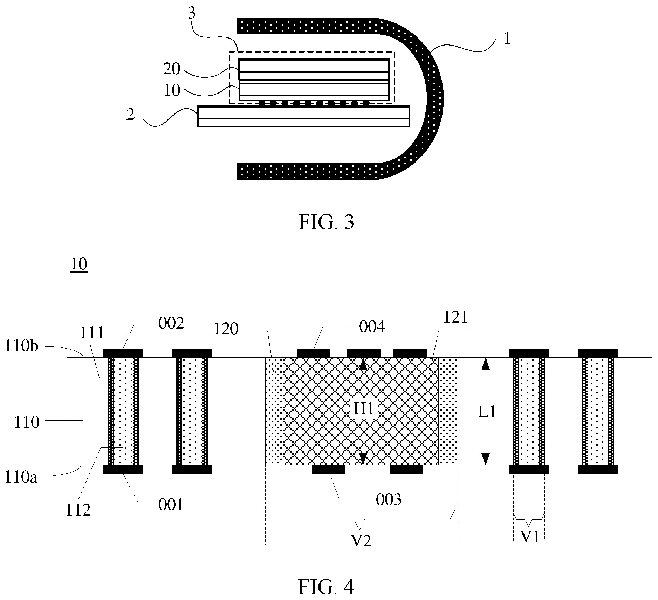

For ease of understanding a package structure provided in embodiments of this application, an application scenario of the package structure is described first. The package structure provided in embodiments of this application may be used in various electronic devices, for example, may be used in a power supply circuit, a microprocessor (micro controller unit, MCU), a central processing unit (central processing unit, CPU), a graphics processing unit (graphics processing unit, GPU), a baseband (baseband) chip, or a system on chip (system on chip, SoC). It should be noted that the package structure provided in embodiments of this application is intended to include but not limited to application to these electronic devices and any other electronic device of a proper type. For example, a power supply circuit is used as an example. As shown in FIG. 3, an electronic device includes a housing 1 and a circuit board 2 disposed in the housing 1. A package module 3 is disposed on the circuit board 2. The package module 3 includes a package substrate 20 and electronic components (not shown in the figure) located on both sides of the package substrate 20. To reduce a risk of mounting the package module 3 on the board, an electronic component located between the package substrate and the circuit board may be first packaged on the package structure 10 and then mounted on the package substrate 20. The following further describes in detail this application with reference to the accompanying drawings.

FIG. 4 is an example of a schematic diagram of a cross-sectional structure of a package structure 10 according to an embodiment of this application. Refer to FIG. 4. The package structure 10 includes a frame plate 110, a first electronic component 121, a filling material 120, and a plurality of conductive connection pads. The frame plate 110 may be made of any dielectric material suitable for forming the frame plate. This is not limited herein. The frame plate 110 has a first surface 110a and a second surface 110b that are opposite and parallel to each other, the frame plate 110 includes a through hole V1, and the frame plate 110 has a hollowed-out region V2. A quantity of the hollowed-out region and a quantity of the through hole are not limited in this application, and may be specifically designed based on an actual product. In FIG. 4, one hollowed-out region and four through holes are used as an example for illustration.

Still refer to FIG. 4. Both the filling material 120 and the first electronic component 121 are located in the hollowed-out region V2. The first electronic component 121 is fastened in the hollowed-out region V2 by using the filling material 120. In other words, the first electronic component 121 and the frame plate 110 are packaged together by using the filling material 120. A quantity of the first electronic component 121 in the hollowed-out region V2 is not limited in this application, and may be specifically designed based on an actual product. In FIG. 4, an example in which one first electronic component 121 is disposed in the hollowed-out region is used for illustration.

Still refer to FIG. 4. The plurality of conductive connection pads include: a first conductive connection pad 001 located on the first surface 110a and electrically connected to the through hole V1, a second conductive connection pad 002 located on the second surface 110b and electrically connected to the through hole V1, a third conductive connection pad 003 located on the first surface 110a and electrically connected to the first electronic component 121, and a fourth conductive connection pad 004 located on the second surface 110b and electrically connected to the first electronic component 121. The first electronic component 121 may be electrically connected to the outside through the third conductive connection pad 003; or the first electronic component 121 may be electrically connected to the outside through the fourth conductive connection pad 004; or the first electronic component 121 may be electrically connected to the outside through the third conductive connection pad 003 and the fourth conductive connection pad 004. A quantity of the third conductive connection pad 003 and a quantity of the fourth conductive connection pad 004 are not limited in this application, and are specifically determined based on a structure of the first electronic component 121.

In this application, both the first conductive connection pad 001 and the third conductive connection pad 003 are located on the first surface 110a, and both the second conductive connection pad 002 and the fourth conductive connection pad 004 are located on the second surface 110b. In this way, on one side of the first surface 110a, a surface of the third conductive connection pad 003 and a surface of the first conductive connection pad 001 may be in a same plane, so that a height of the conductive connection pad of the first electronic component 121, namely, the third conductive connection pad 003, is consistent with a height of the first conductive connection pad 001. On one side of the second surface 110b, a surface of the fourth conductive connection pad 004 and a surface of the second conductive connection pad 002 may be in a same plane, so that a height of the conductive connection pad of the first electronic component 121, namely, the fourth conductive connection pad 004, is consistent with a height of the second conductive connection pad 002.

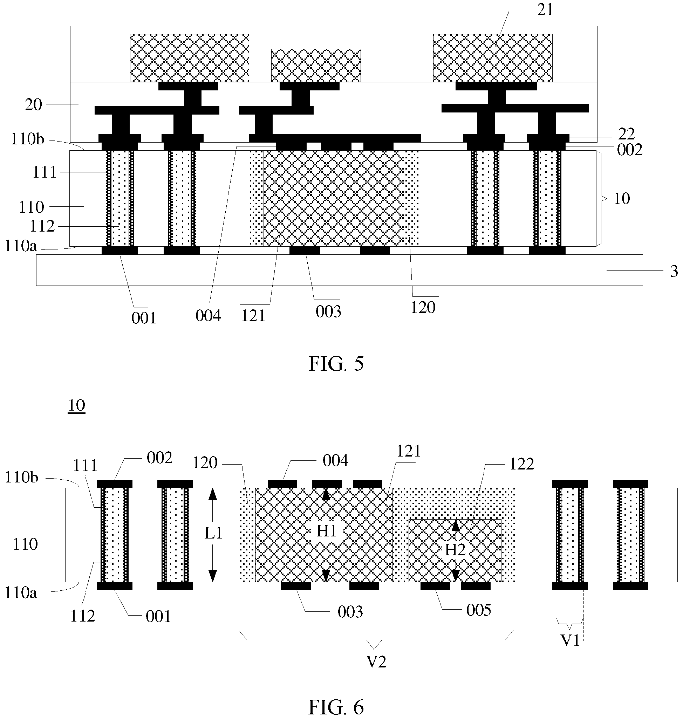

FIG. 5 is a schematic diagram of a structure of an application scenario of a package structure according to an embodiment of this application. As shown in FIG. 5, a package structure 10 provided in an embodiment of this application is mounted on a back of a package substrate 20, and then is mounted on a circuit board 2. In actual application, generally, an electronic component 21 is plastically packaged on a front of the package substrate 20, and a conductive connection pad (not shown in the figure) of the electronic component 21 on the front of the package substrate 20 is led out through a conductive connection pad 22 disposed on the back of the package substrate 20. When the package structure 10 provided in this embodiment of this application is mounted on the back of the package substrate 20, the first electronic component 121 in the package substrate 20 may be packaged on the back of the package substrate 20, and a through hole in the package structure 10 may also be used to lead out the conductive connection pad on the back of the package substrate 20, to resolve a problem of a height difference between the conductive connection pad on the back of the package substrate 20 and the conductive connection pad of the first electronic component 121. In addition, because both the through hole and the first electronic component 121 are packaged in a frame plate 110, in other words, the package structure 10 is a structure in which the through hole and the first electronic component 121 are formed into a same module, the conductive connection pad electrically connected to the through hole and the conductive connection pad electrically connected to the first electronic component 121 may be formed on a same surface. In this way, a height difference between the conductive connection pads located on the same surface may be controlled to be within 20 µm, to reduce a risk of mounting the package structure 10 and the circuit board 2. In addition, in this application, both the through hole and the first electronic component are packaged in the frame plate, and a thickness of the frame plate may be designed based on a height of the first electronic component. Therefore, a problem of a large height difference between the conductive connection pad on the package substrate and the conductive connection pad on the electronic component can be resolved. In addition, in this application, a plurality of first electronic components 121 may be packaged in the package structure 10 and may be mounted on the back of the package substrate 20 through one mounting process, so that a quantity of times of mounting can be reduced, to improve production efficiency and reduce product processing costs. In addition, the package structure 10 provided in this embodiment of this application may be compatible with a conventional device and a conventional manufacturing process, the manufacturing process is simple, and a yield rate is high.

It should be noted that, in this embodiment of this application, the concept of "being in a same plane" does not mean being in a same plane in a strict sense. In a process of preparing the package structure, due to impact of a preparation process and a preparation device, there may be a case in which the surfaces are not strictly in a same plane. This case is caused by a specific preparation procedure, and it cannot be indicated that the case in which the surfaces are not strictly in the same plane goes beyond the protection scope of this application. In addition, a similar understanding is also provided for a location relationship of "parallel", and details are not described herein again.

During specific implementation, in this application, for surfaces that are of different conductive connection pads and that are in a same plane, a height difference within a range of 20 µm is allowed.

For example, the first electronic component 121 may be a component such as an integrated chip, a switch element, a resistor, a capacitor, or a magnetic core. The integrated chip may be a voltage conversion chip, a transformer chip, or the like. This is not limited herein.

During specific implementation, a thickness L1 of the frame plate 110 may be designed based on the height H1 of the first electronic component 121. In this application, heights of first electronic components 121 located in the hollowed-out region are basically the same.

For example, FIG. 6 is a schematic diagram of a cross-sectional structure of another package structure according to an embodiment of this application. As shown in FIG. 6, a package structure 10 provided in this application further includes a second electronic component 122. A plurality of conductive connection pads further include a fifth conductive connection pad 005 located on a first surface 110a and connected to the second electronic component 122. The second electronic component 122 is fastened in a hollowed-out region V2 by using a filling material 120. In other words, a gap that exists after a first electronic component 121 and the second electronic component 122 are placed in the hollowed-out region is filled with the filling material 120. In this application, the first electronic component 121 and the second electronic component 122 are packaged in a same package structure 10. In this way, the first electronic component 121 and the second electronic component 122 may be mounted on a back of the package substrate 20 through one mounting process, so that a quantity of times of mounting can be reduced, to improve production efficiency and reduce product processing costs.

For example, the second electronic component 122 may be a component such as an integrated chip, a switch element, a resistor, a capacitor, or a magnetic core. The integrated chip may be a voltage conversion chip, a transformer chip, or the like. This is not limited herein.

It should be noted that, in this application, a main difference between the first electronic component 121 and the second electronic component 122 lies in that sides of the first electronic component 121 each have a conductive connection pad, and only one side of the second electronic component 122 has a conductive connection pad. For example, in actual application, the first electronic component 121 needs to be electrically connected to both the package substrate and a PCB; and in actual application, the second electronic component 122 only needs to be electrically connected to the package substrate or the PCB. During specific implementation, as shown in FIG. 6, a height H2 of the second electronic component 122 is generally less than or equal to a height H1 of the first electronic component 121. The conductive connection pad is disposed on one side that is of the second electronic component 122 and that is close to the first surface 110a, and on one side of a second surface 110b, the filling material 120 covers the second electronic component 122.

During specific implementation, to implement electrical connection between the conductive connection pads on both sides of the through hole, the through hole may be filled with the conductive material. However, when a thickness of a frame plate 110 is thick, a process of fully filling the through hole with the conductive material 111 is difficult. For example, as shown in FIG. 4 to FIG. 6, the conductive material 111 may be formed on a side wall of the through hole V1, and then a region defined by the conductive material 111 is filled with a resin material 112.

For example, the conductive material 111 may be a metal material, for example, gold, silver, aluminum, zinc, copper, chromium, nickel, or palladium. The resin material 112 may be a material such as epoxy resin. This is not limited herein.

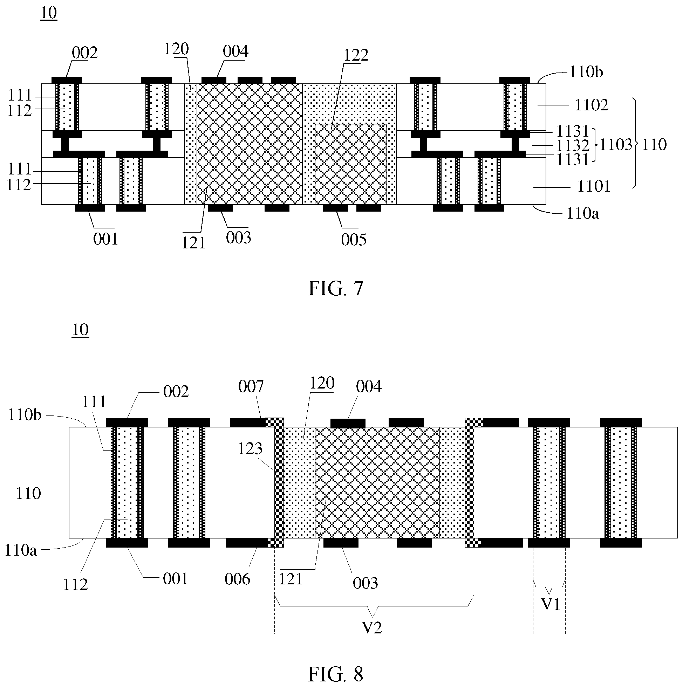

For example, FIG. 7 is a schematic diagram of a cross-sectional structure of another package structure according to an embodiment of this application. In this application, a frame plate 110 may include at least two dielectric material plates disposed in a stacked manner. In the figure, the two dielectric material plates 1101 and 1102 are used as an example for illustration. Each one of dielectric material plates 1101 and 1102 has vias, and one through hole may include one via in each dielectric material plate. A routing layer 1103 is further disposed between any two adjacent dielectric material plates 1101 and 1102, and vias in the any two adjacent dielectric material plates 1101 and 1102 are electrically connected through the routing layer 1103. That is, locations of vias belonging to a same through hole may be different, and different vias are electrically connected through the routing layer 1103. In this way, the package structure 10 may have a possibility of re-routing, so that locations of a first conductive connection pad 001 and a second conductive connection pad 002 may be flexibly set, to reduce a trace pressure of a package substrate 20.

For example, still refer to FIG. 7. The routing layer 1103 may include at least one conductive layer 1131 and an insulation medium layer 1132, and a circuit trace is disposed on the conductive layer 1131. When the routing layer 1103 includes two or more conductive layers 1131, the insulation medium layer 1132 is provided with a medium through hole to connect circuit traces on different conductive layers 1131.

Optionally, FIG. 8 is a schematic diagram of a cross-sectional structure of another package structure according to an embodiment of this application. In a package structure 10, a metal trace 123 may be disposed on a side wall of a hollowed-out region V2 of a frame plate 110, and the metal trace 123 may extend from one side of a first surface 110a to one side of a second surface 110b through the side wall of the hollowed-out region V2. A plurality of conductive connection pads may further include: a sixth conductive connection pad 006 located on the first surface 110a and electrically connected to the metal trace 123, and a seventh conductive connection pad 007 located on the second surface 110b and electrically connected to the metal trace 123. That is, the metal trace 123 is used to replace the through hole, so that a quantity of the through hole V1 in the package structure 10 can be reduced.

A quantity of the metal trace is not limited in this application, and is specifically designed based on an actual product. When there are a plurality of metal traces, the metal traces may be disposed at intervals, to ensure that different metal traces are insulated from each other.

For example, the metal trace may be made of a material such as gold, silver, aluminum, zinc, copper, chromium, nickel, or palladium. This is not limited herein.

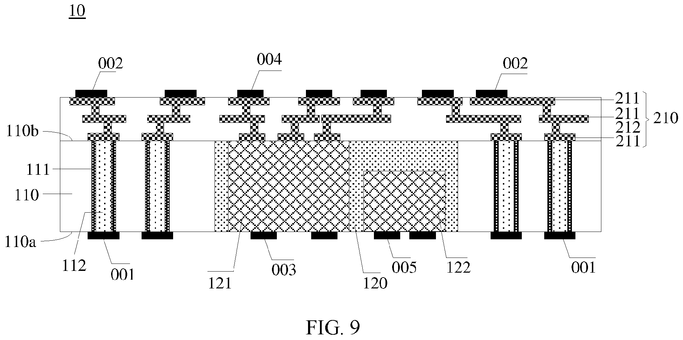

Optionally, FIG. 9 is a schematic diagram of a cross-sectional structure of another package structure according to an embodiment of this application. In this application, the package structure 10 may further include an interconnection line layer 210. The interconnection line layer 210 is located on a second surface 110b of a frame plate 110. Both a second conductive connection pad 002 and a fourth conductive connection pad 004 are located on the interconnection line layer 210. The second conductive connection pad 002 is electrically connected to a through hole through the interconnection line layer 210, and the fourth conductive connection pad 004 is electrically connected to a first electronic component 121 through the interconnection line layer 210. In this way, the interconnection line layer 210 is used, so that locations of the second conductive connection pad 002 and the fourth conductive connection pad 004 may be re-arranged.

During specific implementation, the interconnection line layer 210 may include an insulation medium layer 212 and at least two conductive layers 211. A circuit trace is disposed on each conductive layer 211, and the insulation medium layer 212 is provided with a medium through hole to connect circuit traces on different conductive layers 211.

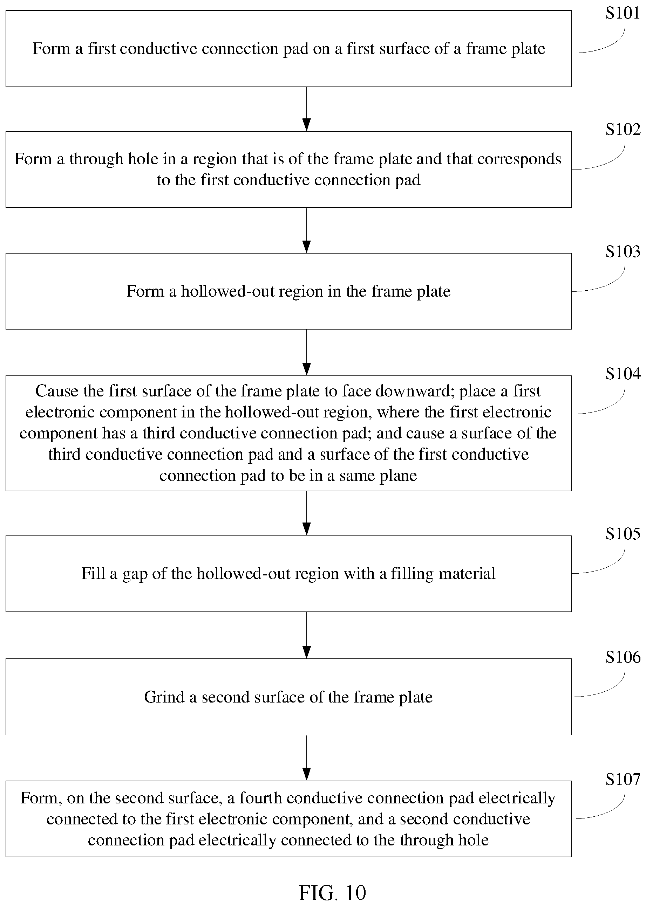

FIG. 10 shows a preparation method of a package structure according to an embodiment of this application. The preparation method may include the following steps.

Step S101: Form a first conductive connection pad on a first surface of a frame plate.

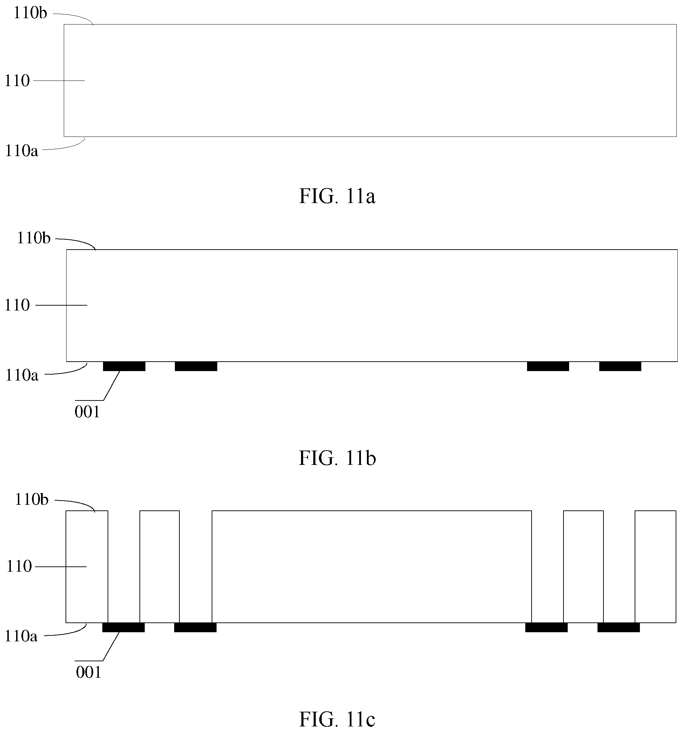

During specific implementation, as shown in FIG. 11a, a frame plate 110 may be made of a dielectric material, and the frame plate 110 has a first surface 110a and a second surface 110b that are opposite and parallel to each other.

During specific implementation, a thickness of the frame plate may be designed based on a height of a first electronic component.

For example, as shown in FIG. 11b, the first surface 110a of the frame plate 110 may be first electroplated with a copper layer, and then the copper layer is etched to form a first conductive connection pad 001.

Step S102: Form a through hole in a region that is of the frame plate 110 and that corresponds to the first conductive connection pad 001.

For example, as shown in FIG. 11c, a hole is made, in a mechanical drilling manner, in the region that is of the frame plate 110 and that corresponds to the first conductive connection pad 001.

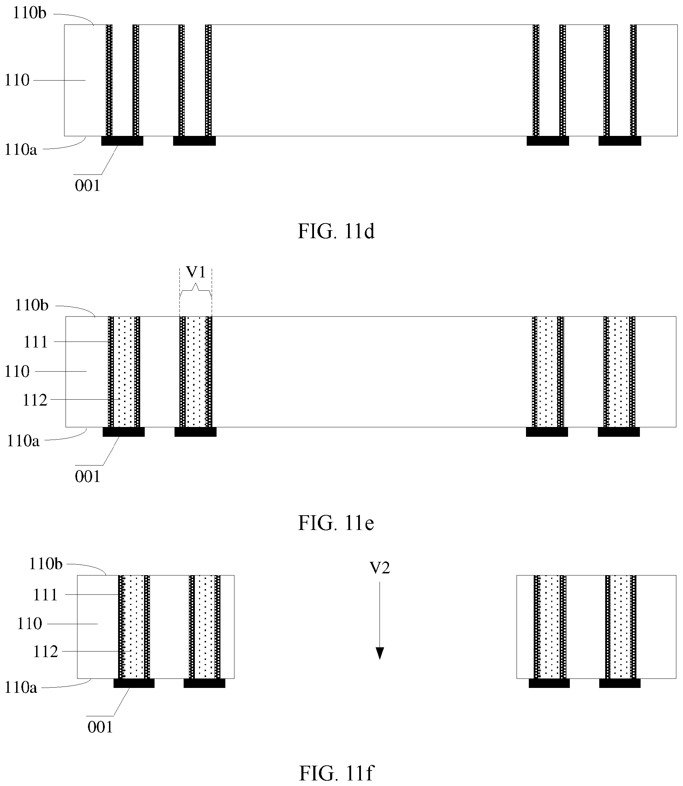

For example, as shown in FIG. 11d, a side wall of the hole may be first plated with a conductive material 111; and then, as shown in FIG. 11e, the hole plated with the conductive material 111 is filled with a resin material 112, to form a through hole V1.

Optionally, in this application, the frame plate 110 may alternatively be formed by a plurality of dielectric material plates. Herein, an example in which the frame plate 110 is formed by two dielectric material plates is used. The forming a first conductive connection pad on a first surface of a frame plate in step S101 and the forming a through hole in a region that is of the frame plate and that corresponds to the first conductive connection pad in step S102 may include the following.

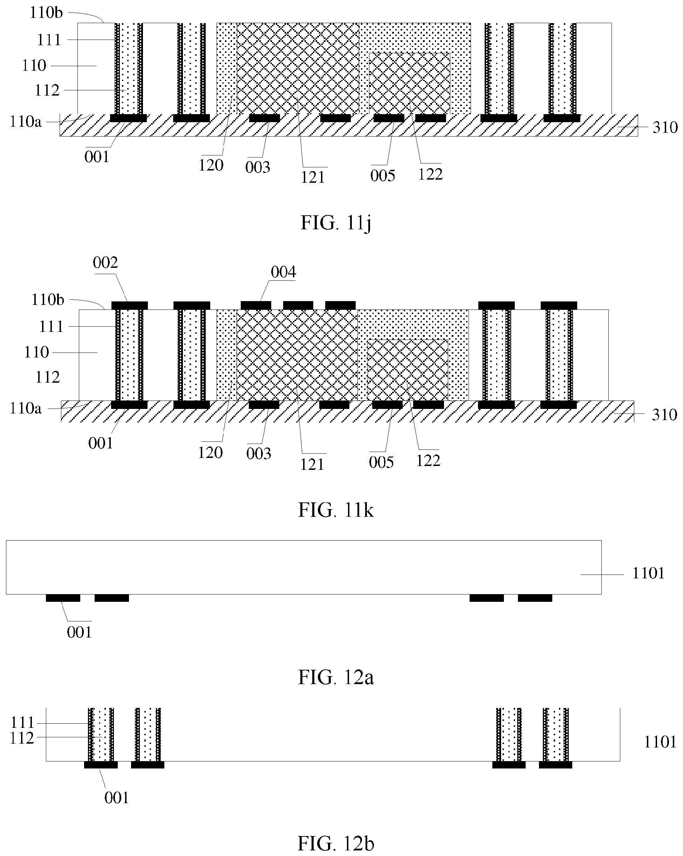

As shown in FIG. 12a, the first conductive connection pad 001 is formed on a surface of one side of a first dielectric material plate 1101.

As shown in FIG. 12b, a first via is formed in a region that is of the first dielectric material plate 1101 and that corresponds to the first conductive connection pad 001.

For example, mechanical drilling may be performed on the region that is of the first dielectric material plate 1101 and that corresponds to the first conductive connection pad 001, to form the first via. Then, a side wall of the first via is plated with the conductive material 111, and the first via plated with the conductive material 111 is filled with the resin material 112.

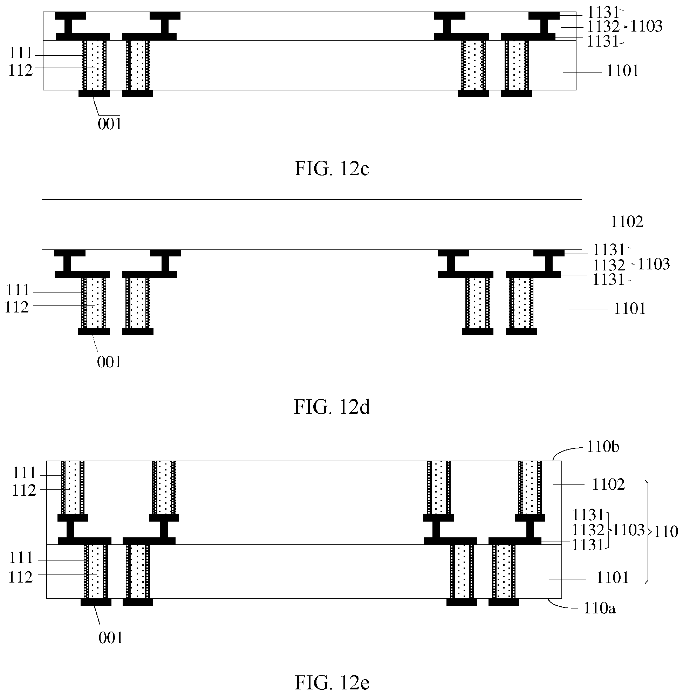

As shown in FIG. 12c, a routing layer 1103 is formed on one side that is of the first dielectric material plate 1101 and that is away from the first conductive connection pad 001, and the routing layer 1103 is electrically connected to the first via of the first dielectric material plate 1101.

For example, the routing layer 1103 may include at least one conductive layer 1131 and an insulation medium layer 114, and a circuit trace is disposed on the conductive layer 113. When the routing layer 1103 includes two or more conductive layers 113, the insulation medium layer 114 is provided with a medium through hole to connect circuit traces on different conductive layers 113.

As shown in FIG. 12d, a second dielectric material plate 1102 is formed on one side that is of the routing layer 1103 and that is away from the first dielectric material plate 1101.

As shown in FIG. 12e, a second via is formed in the second dielectric material plate 1102, and the routing layer 1103 is electrically connected to the second via of the second dielectric material plate 1102. A surface, of the first dielectric material plate 1101, on which the first conductive connection pad 001 is disposed is the first surface 110a of the frame plate 110, and a surface that is of the second dielectric material plate 1102 and that is away from the first conductive connection pad 001 is the second surface 110b of the frame plate 110.

For example, mechanical drilling may be performed on a region that is of the second dielectric material plate 1102 and that corresponds to a to-be-formed second conductive connection pad 002, to form the second via. Then, a side wall of the second via is plated with the conductive material 111, and the second via plated with the conductive material 111 is filled with the resin material 112.

Step S103: As shown in FIG. 11f, form a hollowed-out region V2 in the frame plate 110.

For example, a milling cutter may be used to form the hollowed-out region in the frame plate.

Step S104: Cause the first surface of the frame plate to face downward; place the first electronic component in the hollowed-out region, where the first electronic component has a third conductive connection pad; and cause a surface of the third conductive connection pad and a surface of the first conductive connection pad to be in a same plane.

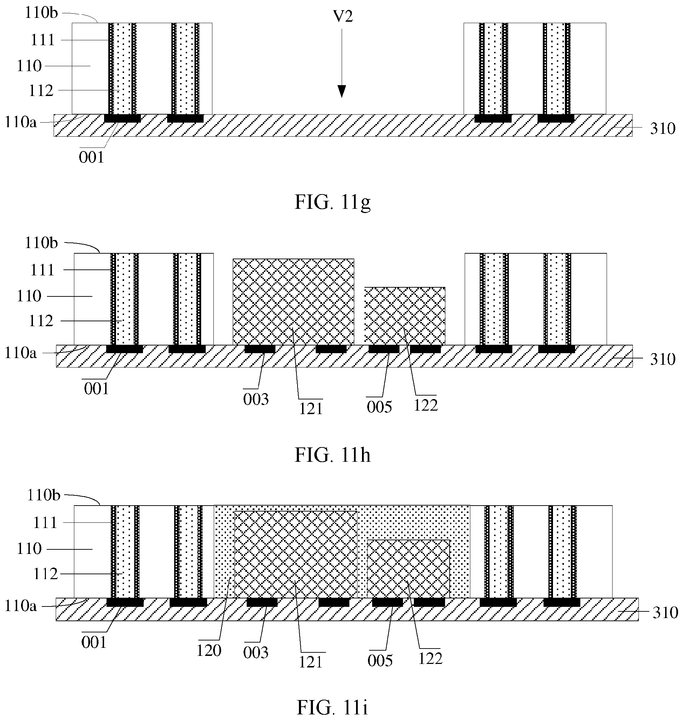

Optionally, as shown in FIG. 11g, before the placing the first electronic component 121 in the hollowed-out region, the first surface 110a of the frame plate 110 is caused to face downward, and the frame plate 110 on which the first conductive connection pad 001, the through hole V1, and the conductive material 111 are formed is placed on a peelable mask 310, to fasten the first electronic component 121 by using stickiness of the peelable mask 310.

For example, a material of the peelable mask may be an ultraviolet photoinduced peelable mask, and the ultraviolet photoinduced peelable mask may lose stickiness after being exposed to ultraviolet light.

As shown in FIG. 11h, the first electronic component 121 is placed in the hollowed-out region V2, where the first electronic component 121 has the third conductive connection pad 003; and the surface of the third conductive connection pad 003 and the surface of the first conductive connection pad 001 are caused to be in the same plane.

Optionally, when a second electronic component needs to be disposed in the package structure, refer to FIG. 11h. The second electronic component 122 may be further disposed in the hollowed-out region V2, where the second electronic component 122 has a fifth conductive connection pad 005. A surface of the fifth conductive connection pad 005 and the surface of the first conductive connection pad 001 are caused to be in a same plane.

During specific implementation, all electronic components may be mounted in the hollowed-out region by using a surface mount technology (surface mount technology, SMT) machine.

Step S105: As shown in FIG. 11i, fill a gap of the hollowed-out region with a filling material 120.

During specific implementation, a dispensing machine may be used to dispense the filling material, for example, a filling adhesive, at a gap that is in the hollowed-out region and that is between the electronic component and the frame plate, and fully fill the hollowed-out region.

Step S106: As shown in FIG. 11j, grind the second surface of the frame plate 110.

During specific implementation, the second surface of the frame plate 110 is ground until a conductive connection part of the first electronic component 121 is exposed, so that a fourth conductive connection pad electrically connected to the first electronic component 121 can be subsequently formed on the second surface.

Step S107: As shown in FIG. 11k, form, on the second surface 110b, the fourth conductive connection pad 004 electrically connected to the first electronic component 121, and the second conductive connection pad 002 electrically connected to the through hole.

For example, the second surface may be first electroplated with the copper layer, and then the copper layer is etched to form the second conductive connection pad and the fourth conductive connection pad.

During specific implementation, when the first surface is placed on the peelable mask, the peelable mask 310 further needs to be peeled off after the second conductive connection pad 002 and the fourth conductive connection pad 004 are formed, to form the package structure 10 shown in FIG. 6.

During specific implementation, when the peelable mask is the ultraviolet photoinduced peelable mask, the ultraviolet photoinduced peelable mask may be caused to lose the stickiness through exposure to the ultraviolet light, and then the peelable mask is peeled off from one side of the first surface.

During specific implementation, when the package structure is prepared, a plurality of package structures are generally prepared on a large frame plate, and after the peelable mask is peeled off, die attaching is performed to form a plurality of independent package structures.

In this application, the plurality of package structures may be simultaneously mounted on a plurality of package substrates before singulation, and then die attaching is performed. In this way, production efficiency can be further improved. Certainly, a single package structure may alternatively be mounted on a single package substrate after die attaching. This is not limited herein.

In this application, each electronic component is packaged in the hollowed-out region of the frame plate, and when the electronic component is placed in the hollowed-out region, a conductive connection pad that is of the electronic component and that is located on one side of the first surface and the first conductive connection pad connected to the through hole are in a same plane. In addition, after each electronic component is packaged in the hollowed-out region of the frame plate, the second surface of the frame plate is ground, so that the conductive connection pad connected to the electronic component and the second conductive connection pad connected to the through hole are formed on the same plane of the frame plate. Therefore, a height difference between the conductive connection pads that are of the package structure and that are in the same plane is controlled to be within 20 µm.

Optionally, in this application, when the first conductive connection pad is formed on the first surface of the frame plate, the method may further include: forming a sixth conductive connection pad on the first surface of the frame plate; after the forming a hollowed-out region in the frame plate, and before the placing the first electronic component in the hollowed-out region, the method further includes: forming a metal trace on a side wall of the hollowed-out region, where the metal trace is electrically connected to the sixth conductive connection pad; and when the fourth conductive connection pad electrically connected to the first electronic component, and the second conductive connection pad electrically connected to the through hole are formed on the second surface, the method further includes: forming, on the second surface, a seventh conductive connection pad electrically connected to the metal trace. That is, the metal trace is used to replace the through hole, so that a quantity of the through hole in the package structure can be reduced. For example, the metal trace may be formed through electroplating. This is not limited herein.

It should be noted that a sequence of some steps in the preparation method provided in this application may be interchanged, and is not limited to the sequence mentioned in the foregoing embodiment.

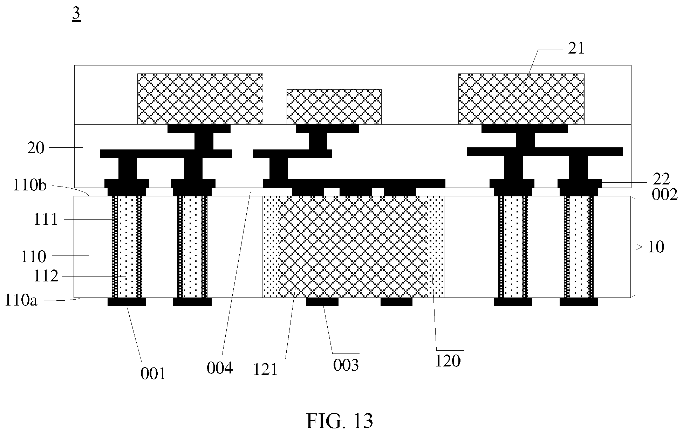

Accordingly, as shown in FIG. 13, this application further provides a package module 3, including a package substrate 20 and a package structure 10 mounted on the package substrate 20. The package structure 10 is any one of the foregoing package structures 10 provided in embodiments of this application. A problem-resolving principle of the package module 3 is similar to that of the foregoing package structure 10. Therefore, for the implementation of the package module 3, refer to the implementation of the foregoing package structure 10, and details are not described again.

During specific implementation, the package substrate may be any structure on which a line is disposed, such as a re-routing layer, a substrate, or a silicon interposer (interposer). This is not limited herein.

For example, the package structure may be mounted on the package substrate by using technologies such as SMT.

In an embodiment, the package structure 10 may be mounted on a back of the package substrate 20, an electronic component 21 is generally disposed on a front of the package substrate 20, and a conductive connection pad (not shown in the figure) of the electronic component 21 on the front of the package substrate 20 is led out through a conductive connection pad 22 disposed on the back of the package substrate 20.

Certainly, during specific implementation, the package structure may alternatively be mounted on the front of the package substrate, or both sides of the package structure are provided with the package substrate. This is not limited herein, and may be designed according to an actual requirement.

Further, in this application, when the package structure is mounted on the package substrate, one side of a first surface of a frame plate in the package structure may be disposed facing the package substrate, or one side of a second surface of the frame plate in the package structure may be disposed facing the package substrate. This is not limited herein, and may be designed according to an actual requirement.

For example, in this application, refer to FIG. 13. When the package structure 10 is mounted on a back of the package substrate 20, one side of the first surface of the frame plate 110 in the package structure 10 may be disposed facing the package substrate 20. In this way, the package structure 10 may not only package a first electronic component 121 on the back of the package substrate 20, but may also use a through hole in the package structure 10 to lead out the conductive connection pad on the back of the package substrate 20, to resolve a problem of a height difference between the conductive connection pad on the back of the package substrate 20 and a conductive connection pad of the first electronic component 121. In addition, because the package structure 10 is a structure in which the through hole and the first electronic component 121 are formed into a same module, a tolerance existing in the package structure 10 basically does not affect conductive connection pads of which surfaces are in a same plane. Therefore, a height difference between the second conductive connection pad 002 and the fourth conductive connection pad 004, and a height difference between the first conductive connection pad 001 and the third conductive connection pad 003 may be controlled to be within 20 µm, to reduce a risk of mounting the package module on the board. In addition, in this application, a plurality of first electronic components 121 may be packaged in the package structure 10 and may be mounted on the back of the package substrate 20 through one mounting process. Compared with the conventional technology in which each first electronic component 121 and an elevating plate are separately mounted, a quantity of times of mounting can be obviously reduced, to improve production efficiency and reduce product processing costs.

Accordingly, this application further provides an electronic device. As shown in FIG. 3, the electronic device includes a housing 1, a circuit board 2 located in the housing 1, and a package module 3. The package module 3 is located on the circuit board 2, and the package module 3 is electrically connected to the circuit board 2. For example, the circuit board may be a PCB. A problem-resolving principle of the electronic device is similar to that of the foregoing package module 3. Therefore, for implementation of the electronic device, refer to implementation of the foregoing package module 3, and details are not described again.

During specific implementation, the electronic device may be a power supply circuit, and the power supply circuit is configured to perform functions such as conversion, distribution, and detection of electric energy, and other electric energy management and control.

In another modified embodiment of this application, the electronic device may alternatively be a microprocessor, a central processing unit, a graphics processing unit, a baseband chip, a system on chip, or the like.

## Claims

1. A package structure (10), comprising: a frame plate (110), a first electronic component (121), a filling material (120), and a plurality of conductive connection pads, wherein
the frame plate (110) is made of a dielectric material, the frame plate (110) has a first surface (110a) and a second surface (110b) that are opposite and parallel to each other, the frame plate (110) comprises a through hole (V1), and the frame plate (110) has a hollowed-out region (V2);
both the filling material (120) and the first electronic component (121) are located in the hollowed-out region (V2), and the first electronic component (121) is fastened in the hollowed-out region (V2) by using the filling material (120); and
the plurality of conductive connection pads comprise: a first conductive connection pad (001) located on the first surface (110a) and electrically connected to the through hole (V1), a second conductive connection pad (002) located on the second surface (110b) and electrically connected to the through hole (V1), a third conductive connection pad (003) located on the first surface (110a) and electrically connected to the first electronic component (121), and a fourth conductive connection pad (004) located on the second surface (110b) and electrically connected to the first electronic component (121),
wherein the frame plate (110) comprises at least two dielectric material plates (1101; 1102) disposed in a stacked manner;
the through hole (V1) comprises vias located in each dielectric material plate (1101; 1102); and
a routing layer (1103) is further disposed between any two adjacent dielectric material plates (1101; 1102), and vias in the any two adjacent dielectric material plates (1101; 1102) are electrically connected through the routing layer (1103), wherein the routing layer (1103) includes at least one conductive layer (1131) and an insulation medium layer (1132) and a circuit trace is disposed on the conductive layer (1131).

2. The package structure (10) according to claim 1, wherein the frame plate (110) further comprises a metal trace extending from one side of the first surface (110a) to one side of the second surface (110b) through a side wall of the hollowed-out region (V2); and
the plurality of conductive connection pads further comprise: a sixth conductive connection pad located on the first surface (110a) and electrically connected to the metal trace, and a seventh conductive connection pad located on the second surface (110b) and electrically connected to the metal trace.

3. The package structure (10) according to any one of claims 1 to 2, wherein the package structure (10) further comprises a second electronic component (122), and the plurality of conductive connection pads further comprise a fifth conductive connection pad (005) located on the first surface (110a) and connected to the second electronic component (122); and
the second electronic component (122) is fastened in the hollowed-out region (V2) by using the filling material (120).

4. The package structure (10) according to any one of claims 1 to 3, wherein a conductive material (111) is formed on a side wall of the through hole (V1), and a region defined by the conductive material (111) is further filled with a resin material.

5. The package structure (10) according to any one of claims 1 to 3, wherein the through hole (V1) is filled with a conductive material (111).

6. A package module (3), comprising a package substrate (20) and the package structure (10) according to any one of claims 1 to 5 that is mounted on the package substrate (20).

7. An electronic device, comprising: a housing (1), a circuit board (2) located in the housing (1), and the package module (3) according to claim 6, wherein the package module (3) is located on the circuit board (2), and the package module (3) is electrically connected to the circuit board (2).

8. A preparation method of a package structure (10), comprising:
forming a first conductive connection pad (001) on a first surface (110a) of a frame plate (110);
forming a through hole (V1) in a region that is of the frame plate (110) and that corresponds to the first conductive connection pad (001);
forming a hollowed-out region (V2) in the frame plate (110);
causing the first surface (110a) of the frame plate (110) to face downward; placing a first electronic component (121) in the hollowed-out region (V2), wherein the first electronic component (121) has a third conductive connection pad (003); and causing a surface of the third conductive connection pad (003) and a surface of the first conductive connection pad (001) to be in a same plane;
filling a gap of the hollowed-out region (V2) with a filling material (120);
grinding a second surface (110b) of the frame plate (110), wherein the second surface (110b) is opposite and parallel to the first surface (110a); and
forming, on the second surface (110b), a fourth conductive connection pad (004) electrically connected to the first electronic component (121), and a second conductive connection pad (002) electrically connected to the through hole (V1),
wherein the frame plate (110) comprises a first dielectric material plate (1101), a second dielectric material plate (1102), and a routing layer (1103), wherein the routing layer (1103) includes at least one conductive layer (1131) and an insulation medium layer (1132) and a circuit trace is disposed on the conductive layer (1131); and the forming a first conductive connection pad (001) on a first surface (110a) of a frame plate (110), and the forming a through hole (V1) in a region that is of the frame plate (110) and that corresponds to the first conductive connection pad (001) comprise:
forming the first conductive connection pad (001) on a surface of one side of the first dielectric material plate (1101);
forming a first via in a region that is of the first dielectric material plate (1101) and that corresponds to the first conductive connection pad (001);
forming the routing layer (1103) on one side that is of the first dielectric material plate (1101) and that is away from the first conductive connection pad (001), wherein the routing layer (1103) is electrically connected to the first via of the first dielectric material plate (1101);
forming the second dielectric material plate (1102) on one side that is of the routing layer (1103) and that is away from the first dielectric material plate (1101); and
forming a second via in the second dielectric material plate (1102), wherein the routing layer (1103) is electrically connected to the second via of the second dielectric material plate (1102).

9. The preparation method according to claim 8, wherein before the placing a first electronic component (121) in the hollowed-out region (V2), the method further comprises: placing the frame plate (110) on which the first conductive connection pad (001) and the through hole (V1) are formed on a peelable mask (310); and
after the forming, on the second surface (110b), a fourth conductive connection pad (004) electrically connected to the first electronic component (121), and a second conductive connection pad (002) electrically connected to the through hole (V1), the method further comprises: peeling off the peelable mask (310).

10. The preparation method according to claim 9, wherein a material of the peelable mask (310) is an ultraviolet photoinduced peelable mask (310); and
the peeling off the peelable mask (310) comprises: peeling off the peelable mask (310) through exposure to ultraviolet light.

11. The preparation method according to any one of claims 8 to 10, wherein the forming a through hole (V1) in a region that is of the frame plate (110) and that corresponds to the first conductive connection pad (001) comprises:
making a hole in the region that is of the frame plate (110) and that corresponds to the first conductive connection pad (001);
plating a side wall of the hole with a conductive material (111); and
filling, with a resin material, the hole plated with the conductive material (111).

12. The preparation method according to any one of claims 8 to 11, wherein when the first conductive connection pad (001) is formed on the first surface (110a) of the frame plate (110), the method further comprises: forming a sixth conductive connection pad on the first surface (110a) of the frame plate (110);
after the forming a hollowed-out region (V2) in the frame plate (110), and before the placing a first electronic component (121) in the hollowed-out region (V2), the method further comprises: forming a metal trace on a side wall of the hollowed-out region (V2), wherein the metal trace is electrically connected to the sixth conductive connection pad; and
when the fourth conductive connection pad (004) electrically connected to the first electronic component (121), and the second conductive connection pad (002) electrically connected to the through hole (V1) are formed on the second surface (110b), the method further comprises: forming, on the second surface (110b), a seventh conductive connection pad electrically connected to the metal trace.

13. The preparation method according to any one of claims 8 to 12, wherein after the forming a hollowed-out region (V2) in the frame plate (110), and before the filling a gap of the hollowed-out region (V2) with a filling material (120), the method further comprises:
placing a second electronic component (122) in the hollowed-out region (V2), wherein the second electronic component (122) has a fifth conductive connection pad (005); and causing a surface of the fifth conductive connection pad (005) of the second electronic component (122) and a surface of the first conductive connection pad (001) to be in a same plane.

## Patentansprüche

1. Verpackungsstruktur (10), umfassend: eine Rahmenplatte (110), ein erstes elektronisches Bauteil (121), ein Füllmaterial (120) und eine Vielzahl von leitenden Verbindungsflächen, wobei die Rahmenplatte (110) aus einem dielektrischen Material besteht, die Rahmenplatte (110) eine erste Oberfläche (110a) und eine zweite Oberfläche (110b) aufweist, die einander gegenüberliegen und parallel zueinander sind, die Rahmenplatte (110) ein Durchgangsloch (V1) umfasst und die Rahmenplatte (110) einen ausgehöhlten Bereich (V2) aufweist;
sich sowohl das Füllmaterial (120) als auch das erste elektronische Bauteil (121) in dem ausgehöhlten Bereich (V2) befinden und das erste elektronische Bauteil (121) in dem ausgehöhlten Bereich (V2) unter Verwendung des Füllmaterials (120) befestigt ist; und
die Vielzahl von leitenden Verbindungsflächen Folgendes umfasst:
eine erste leitende Verbindungsfläche (001), die sich auf der ersten Oberfläche (110a) befindet und elektrisch mit dem Durchgangsloch (V1) verbunden ist, eine zweite leitende Verbindungsfläche (002), die sich auf der zweiten Oberfläche (110b) befindet und elektrisch mit dem Durchgangsloch (V1) verbunden ist, eine dritte leitendes Verbindungsfläche (003), die sich auf der ersten Oberfläche (110a) befindet und elektrisch mit dem ersten elektronische Bauteil (121) verbunden ist, und eine vierte leitende Verbindungsfläche (004), die sich auf der zweiten Oberfläche (110b) befindet und elektrisch mit dem ersten elektronischen Bauteil (121) verbunden ist,
wobei die Rahmenplatte (110) mindestens zwei Platten (1101; 1102) aus dielektrischem Material umfasst, die übereinander angeordnet sind;
das Durchgangsloch (V1) Durchkontaktierungen umfasst, die sich in jeder Platte aus dielektrischem Material (1101; 1102) befinden; und
eine Routing-Schicht (1103) ferner zwischen zwei beliebigen benachbarten Platten (1101; 1102) aus dielektrischem Material angeordnet ist und Durchkontaktierungen in den zwei beliebigen benachbarten Platten (1101; 1102) aus dielektrischem Material durch die Routing-Schicht (1103) hindurch elektrisch verbunden sind, wobei die Routing-Schicht (1103) mindestens eine leitende Schicht (1131) und eine Isolationsmittelschicht (1132) umfasst und eine Leiterbahn auf der leitenden Schicht (1131) angeordnet ist.

2. Verpackungsstruktur (10) nach Anspruch 1, wobei die Rahmenplatte (110) ferner eine Metallbahn umfasst, die sich von einer Seite der ersten Oberfläche (110a) zu einer Seite der zweiten Oberfläche (110b) durch eine Seitenwand des ausgehöhlten Bereichs (V2) erstreckt; und
die Vielzahl von leitenden Verbindungsflächen ferner Folgendes umfasst: eine sechste leitende Verbindungsfläche, die sich auf der ersten Oberfläche (110a) befindet und elektrisch mit der Metallbahn verbunden ist, und eine siebte leitende Verbindungsfläche, die sich auf der zweiten Oberfläche (110b) befindet und elektrisch mit der Metallbahn verbunden ist.

3. Verpackungsstruktur (10) nach einem der Ansprüche 1 bis 2, wobei die Verpackungsstruktur (10) ferner ein zweites elektronisches Bauteil (122) umfasst und die Vielzahl von leitenden Verbindungsflächen ferner eine fünfte leitende Verbindungsfläche (005) umfasst, die sich auf der ersten Oberfläche (110a) befindet und mit dem zweiten elektronischen Bauteil (122) verbunden ist; und
das zweite elektronische Bauteil (122) unter Verwendung des Füllmaterials (120) in dem ausgehöhlten Bereich (V2) befestigt wird.

4. Verpackungsstruktur (10) nach einem der Ansprüche 1 bis 3, wobei ein leitendes Material (111) an einer Seitenwand des Durchgangslochs (V1) ausgebildet ist und ein Bereich, der durch das leitende Material (111) definiert ist, ferner mit einem Harzmaterial gefüllt ist.

5. Verpackungsstruktur (10) nach einem der Ansprüche 1 bis 3, wobei das Durchgangsloch (V1) mit einem leitenden Material (111) gefüllt ist.

6. Verpackungsmodul (3), das ein Verpackungssubstrat (20) und die Verpackungsstruktur (10) nach einem der Ansprüche 1 bis 5 umfasst, die auf dem Verpackungssubstrat (20) montiert ist.

7. Elektronische Vorrichtung, umfassend: ein Gehäuse (1), eine Leiterplatte (2), die sich in dem Gehäuse (1) befindet und das Verpackungsmodul (3) nach Anspruch 6, wobei sich das Verpackungsmodul (3) auf der Leiterplatte (2) befindet und das Verpackungsmodul (3) mit der Leiterplatte (2) elektrisch verbunden ist.

8. Herstellungsverfahren für eine Verpackungsstruktur (10), umfassend:
Ausbilden einer ersten leitenden Verbindungsfläche (001) auf einer ersten Oberfläche (110a) einer Rahmenplatte (110);
Ausbilden eines Durchgangslochs (V1) in einem Bereich, der zu der Rahmenplatte (110) gehört und welcher der ersten leitenden Verbindungsfläche (001) entspricht;
Ausbilden eines ausgehöhlten Bereichs (V2) in der Rahmenplatte (110);
Bewirken, dass die erste Oberfläche (110a) der Rahmenplatte (110) nach unten weist; Platzieren eines ersten elektronischen Bauteils (121) in dem ausgehöhlten Bereich (V2), wobei das erste elektronische Bauteil (121) eine dritte leitende Verbindungsfläche (003) aufweist; und Bewirken, dass eine Oberfläche der dritten leitenden Verbindungsfläche (003) und eine Oberfläche der ersten leitenden Verbindungsfläche (001) in einer gleichen Ebene liegen;
Füllen eines Spalts des ausgehöhlten Bereichs (V2) mit einem Füllmaterial (120);
Schleifen einer zweiten Oberfläche (110b) der Rahmenplatte (110), wobei die zweite Oberfläche (110b) der ersten Oberfläche (110a) gegenüberliegt und parallel zu dieser ist; und
Ausbilden, auf der zweiten Oberfläche (110b), einer vierten leitenden Verbindungsfläche (004), die elektrisch mit dem ersten elektronischen Bauteil (121) verbunden ist, und einer zweiten leitenden Verbindungsfläche (002), die elektrisch mit dem Durchgangsloch (V1) verbunden ist,
wobei die Rahmenplatte (110) eine erste Platte (1101) aus dielektrischem Material, eine zweite Platte (1102) aus dielektrischem Material und eine Routing-Schicht (1103) umfasst, wobei die Routing-Schicht (1103) mindestens eine leitende Schicht (1131) und eine Isolationsmittelschicht (1132) beinhaltet und eine Leiterbahn auf der leitenden Schicht (1131) angeordnet ist;
und das Ausbilden einer ersten leitenden Verbindungsfläche (001) auf einer ersten Oberfläche (110a) einer Rahmenplatte (110) und das Ausbilden eines Durchgangslochs (V1) in einem Bereich, der zu der Rahmenplatte (110) gehört und welcher der ersten leitenden Verbindungsfläche (001) entspricht, Folgendes umfassen:
Ausbilden der ersten leitenden Verbindungsfläche (001) auf einer Oberfläche einer Seite der ersten Platte (1101) aus dielektrischem Material;
Ausbilden einer ersten Durchkontaktierung in einem Bereich, der zu der ersten Platte (1101) aus dielektrischem Material gehört und welcher der ersten leitenden Verbindungsfläche (001) entspricht;
Ausbilden der Routing-Schicht (1103) auf einer Seite, die zu der ersten Platte (1101) aus dielektrischem Material gehört und die von der ersten leitenden Verbindungsfläche (001) entfernt ist, wobei die Routing-Schicht (1103) elektrisch mit der ersten Durchkontaktierung der ersten Platte (1101) aus dielektrischem Material verbunden ist;
Ausbilden der zweiten Platte (1102) aus dielektrischem Material auf einer Seite, die zu der Routing-Schicht (1103) gehört und die von der ersten Platte (1101) aus dielektrischem Material entfernt ist; und
Ausbilden einer zweiten Durchkontaktierung in der zweiten Platte (1102) aus dielektrischem Material, wobei die Routing-Schicht (1103) elektrisch mit der zweiten Durchkontaktierung der zweiten Platte (1102) aus dielektrischem Material verbunden ist.

9. Herstellungsverfahren nach Anspruch 8, wobei das Verfahren vor dem Platzieren eines ersten elektronischen Bauteils (121) in dem ausgehöhlten Bereich (V2) ferner Folgendes umfasst: Platzieren der Rahmenplatte (110), auf der die erste leitende Verbindungsfläche (001) und das Durchgangsloch (V1) ausgebildet sind, auf einer abziehbaren Maske (310); und
das Verfahren nach dem Ausbilden, auf der zweiten Oberfläche (110b), einer vierten leitenden Verbindungsfläche (004), die elektrisch mit dem ersten elektronischen Bauteil (121) verbunden ist, und einer zweiten leitenden Verbindungsfläche (002), die elektrisch mit dem Durchgangsloch (V1) verbunden ist, ferner Folgendes umfasst: Abziehen der abziehbaren Maske (310).

10. Herstellungsverfahren nach Anspruch 9, wobei ein Material der abziehbaren Maske (310) eine ultraviolette photoinduzierte abziehbare Maske (310) ist; und
das Abziehen der abziehbaren Maske (310) Folgendes umfasst: Abziehen der abziehbaren Maske (310) durch Einwirkung von ultraviolettem Licht.

11. Herstellungsverfahren nach einem der Ansprüche 8 bis 10, wobei das Ausbilden eines Durchgangslochs (V1) in einem Bereich, der zu der Rahmenplatte (110) gehört und welcher der ersten leitenden Verbindungsfläche (001) entspricht, Folgendes umfasst:
Bilden eines Lochs in dem Bereich, der zu der Rahmenplatte (110) gehört und welcher der ersten leitenden Verbindungsfläche (001) entspricht;
Beschichten einer Seitenwand des Lochs mit einem leitenden Material (111); und
Füllen, mit einem Harzmaterial, des Lochs, das mit dem leitenden Material (111) beschichtet ist.

12. Herstellungsverfahren nach einem der Ansprüche 8 bis 11, wobei das Verfahren, wenn die erste leitende Verbindungsfläche (001) auf der ersten Oberfläche (110a) der Rahmenplatte (110) ausgebildet wird, ferner Folgendes umfasst: Ausbilden einer sechsten leitenden Verbindungsfläche auf der ersten Oberfläche (110a) der Rahmenplatte (110);
das Verfahren nach dem Ausbilden eines ausgehöhlten Bereichs (V2) in der Rahmenplatte (110) und vor dem Platzieren eines ersten elektronischen Bauteils (121) in dem ausgehöhlten Bereich (V2) ferner Folgendes umfasst: Ausbilden einer Metallbahn auf einer Seitenwand des ausgehöhlten Bereichs (V2), wobei die Metallbahn elektrisch mit der sechsten leitenden Verbindungsfläche verbunden ist; und
das Verfahren, wenn die vierte leitende Verbindungsfläche (004), die elektrisch mit dem ersten elektronischen Bauteil (121) verbunden ist, und die zweite leitende Verbindungsfläche (002), die elektrisch mit dem Durchgangsloch (V1) verbunden ist, auf der zweiten Oberfläche (110b) ausgebildet werden, ferner Folgendes umfasst: Ausbilden, auf der zweiten Oberfläche (110b), einer siebten leitenden Verbindungsfläche, die elektrisch mit der Metallbahn verbunden ist.

13. Herstellungsverfahren nach einem der Ansprüche 8 bis 12, wobei das Verfahren nach dem Ausbilden eines ausgehöhlten Bereichs (V2) in der Rahmenplatte (110) und vor dem Füllen eines Spalts des ausgehöhlten Bereichs (V2) mit einem Füllmaterial (120) ferner Folgendes umfasst:
Platzieren eines zweiten elektronischen Bauteils (122) in dem ausgehöhlten Bereich (V2), wobei das zweite elektronische Bauteil (122) eine fünfte leitende Verbindungsfläche (005) aufweist; und Bewirken, dass eine Oberfläche der fünften leitenden Verbindungsfläche (005) des zweiten elektronischen Bauteils (122) und eine Oberfläche der ersten leitenden Verbindungsfläche (001) in einer gleichen Ebene liegen.

## Revendications

1. Structure d'encapsulation (10), comprenant : une plaque de cadre (110), un premier composant électronique (121), un matériau de remplissage (120), et une pluralité de plots de connexion conducteurs, dans laquelle
la plaque de cadre (110) est constituée d'un matériau diélectrique, la plaque de cadre (110) a une première surface (110a) et une seconde surface (110b) qui sont opposées et parallèles l'une à l'autre, la plaque de cadre (110) comprend un trou traversant (V1), et la plaque de cadre (110) a une zone évidée (V2) ;
le matériau de remplissage (120) et le premier composant électronique (121) sont situés dans la zone évidée (V2), et le premier composant électronique (121) est fixé dans la zone évidée (V2) à l'aide du matériau de remplissage (120) ; et
la pluralité de plots de connexion conducteurs comprend : un premier plot de connexion conducteur (001) situé sur la première surface (110a) et connecté électriquement au trou traversant (V1), un deuxième plot de connexion conducteur (002) situé sur la seconde surface (110b) et connecté électriquement au trou traversant (V1), un troisième plot de connexion conducteur (003) situé sur la première surface (110a) et connecté électriquement au premier composant électronique (121), et un quatrième plot de connexion conducteur (004) situé sur la seconde surface (110b) et connecté électriquement au premier composant électronique (121),
dans lequel la plaque de cadre (110) comprend au moins deux plaques de matériau diélectrique (1101 ; 1102) disposées de manière empilée ;
le trou traversant (V1) comprend des vias situés dans chaque plaque de matériau diélectrique (1101 ; 1102) ; et
une couche de routage (1103) est également disposée entre deux plaques quelconques de matériau diélectrique (1101 ; 1102) adjacentes, et des vias dans les deux plaques quelconques de matériau diélectrique (1101 ; 1102) adjacentes sont connectés électriquement à travers la couche de routage (1103), dans laquelle la couche de routage (1103) comporte au moins une couche conductrice (1131) et une couche de milieu isolant (1132) et une trace de circuit est disposée sur la couche conductrice (1131).

2. Structure d'encapsulation (10) selon la revendication 1, dans laquelle la plaque de cadre (110) comprend également une trace métallique se prolongeant d'un côté de la première surface (110a) à un côté de la seconde surface (110b) à travers une paroi latérale de la zone évidée (V2) ; et
la pluralité de plots de connexion conducteurs comprennent également : un sixième plot de connexion conducteur situé sur la première surface (110a) et connecté électriquement à la trace métallique, et un septième plot de connexion conducteur situé sur la seconde surface (110b) et connecté électriquement à la trace métallique.

3. Structure d'encapsulation (10) selon l'une quelconque des revendications 1 et 2, dans laquelle la structure d'encapsulation (10) comprend également un second composant électronique (122), et la pluralité de plots de connexion conducteurs comprend également un cinquième plot de connexion conducteur (005) situé sur la première surface (110a) et connecté au second composant électronique (122) ; et
le second composant électronique (122) est fixé dans la zone évidée (V2) à l'aide du matériau de remplissage (120).

4. Structure d'encapsulation (10) selon l'une quelconque des revendications 1 à 3, dans laquelle un matériau conducteur (111) est formé sur une paroi latérale du trou traversant (V1), et une zone définie par le matériau conducteur (111) est également remplie d'un matériau de résine.

5. Structure d'encapsulation (10) selon l'une quelconque des revendications 1 à 3, dans laquelle le trou traversant (V1) est rempli d'un matériau conducteur (111).

6. Module d'encapsulation (3), comprenant un substrat d'encapsulation (20) et la structure d'encapsulation (10) selon l'une quelconque des revendications 1 à 5 qui est montée sur le substrat d'encapsulation (20).

7. Dispositif électronique, comprenant : un boîtier (1), une carte de circuit imprimé (2) située dans le boîtier (1), et le module d'encapsulation (3) selon la revendication 6, dans lequel le module d'encapsulation (3) est situé sur la carte de circuit imprimé (2), et le module d'encapsulation (3) est connecté électriquement à la carte de circuit imprimé (2).

8. Procédé de préparation d'une structure d'encapsulation (10), comprenant :
la formation d'un premier plot de connexion conducteur (001) sur une première surface (110a) d'une plaque de cadre (110) ;
la formation d'un trou traversant (V1) dans une zone qui appartient à la plaque de cadre (110) et qui correspond au premier plot de connexion conducteur (001) ;
la formation d'une zone évidée (V2) dans la plaque de cadre (110) ;
le fait d'amener la première surface (110a) de la plaque de cadre (110) à être orientée vers le bas ; le placement d'un premier composant électronique (121) dans la zone évidée (V2),
dans lequel le premier composant électronique (121) a un troisième plot de connexion conducteur (003) ; et le fait d'amener une surface du troisième plot de connexion conducteur (003) et une surface du premier plot de connexion conducteur (001) à être dans un même plan ;
le remplissage d'un espace de la zone évidée (V2) avec un matériau de remplissage (120) ;
le meulage d'une seconde surface (110b) de la plaque de cadre (110), dans lequel la seconde surface (110b) est opposée et parallèle à la première surface (110a) ; et
la formation, sur la seconde surface (110b), d'un quatrième plot de connexion conducteur (004) connecté électriquement au premier composant électronique (121), et un deuxième plot de connexion conducteur (002) connecté électriquement au trou traversant (V1),
dans lequel la plaque de cadre (110) comprend une première plaque de matériau diélectrique (1101), une seconde plaque de matériau diélectrique (1102), et une couche de routage (1103), dans lequel la couche de routage (1103) comporte au moins une couche conductrice (1131) et une couche de milieu isolant (1132), et
une trace de circuit est disposée sur la couche conductrice (1131) ; et la formation d'un premier plot de connexion conducteur (001) sur une première surface (110a) d'une plaque de cadre (110), et la formation d'un trou traversant (V1) dans une zone qui appartient à la plaque de cadre (110) et qui correspond au premier plot de connexion conducteur (001) comprennent :
la formation du premier plot de connexion conducteur (001) sur une surface d'un côté de la première plaque de matériau diélectrique (1101) ;
la formation d'un premier via dans une zone qui appartient à la première plaque de matériau diélectrique (1101) et qui correspond au premier plot de connexion conducteur (001) ;
la formation de la couche de routage (1103) sur un côté qui appartient à la première plaque de matériau diélectrique (1101) et qui est éloigné du premier plot de connexion conducteur (001),
dans lequel la couche de routage (1103) est connectée électriquement au premier via de la première plaque de matériau diélectrique (1101) ;
la formation de la seconde plaque de matériau diélectrique (1102) sur un côté qui appartient à la couche de routage (1103) et qui est éloigné de la première plaque de matériau diélectrique (1101) ; et
la formation d'un second via dans la seconde plaque de matériau diélectrique (1102), dans lequel la couche de routage (1103) est connectée électriquement au second via de la seconde plaque de matériau diélectrique (1102).

9. Procédé de préparation selon la revendication 8, dans lequel avant le placement d'un premier composant électronique (121) dans la zone évidée (V2), le procédé comprend également : le placement de la plaque de cadre (110) sur laquelle sont formés le premier plot de connexion conducteur (001) et le trou traversant (V1) sur un masque pelable (310) ; et
après la formation, sur la seconde surface (110b), d'un quatrième plot de connexion conducteur (004) connecté électriquement au premier composant électronique (121), et d'un deuxième plot de connexion conducteur (002) connecté électriquement au trou traversant (V1), le procédé comprend également : le décollement du masque pelable (310).

10. Procédé de préparation selon la revendication 9, dans lequel un matériau du masque pelable (310) est un masque pelable photoinduit par ultraviolets (310) ; et
le décollement du masque pelable (310) comprend : le décollement du masque pelable (310) par exposition à une lumière ultraviolette.

11. Procédé de préparation selon l'une quelconque des revendications 8 à 10, dans lequel la formation d'un trou traversant (V1) dans une zone qui appartient à la plaque de cadre (110) et qui correspond au premier plot de connexion conducteur (001) comprend :
la fabrication d'un trou dans la zone qui appartient à la plaque de cadre (110) et qui correspond au premier plot de connexion conducteur (001) ;
le placage d'une paroi latérale du trou avec un matériau conducteur (111) ; et
le remplissage, avec un matériau en résine, du trou plaqué avec le matériau conducteur (111).

12. Procédé de préparation selon l'une quelconque des revendications 8 à 11, dans lequel lorsque le premier plot de connexion conducteur (001) est formé sur la première surface (110a) de la plaque de cadre (110), le procédé comprend également : la formation d'un sixième plot de connexion conducteur sur la première surface (110a) de la plaque de cadre (110) ;
après la formation d'une zone évidée (V2) dans la plaque de cadre (110), et avant le placement d'un premier composant électronique (121) dans la zone évidée (V2), le procédé comprend également : la formation d'une trace métallique sur une paroi latérale de la zone évidée (V2), dans lequel la trace métallique est connectée électriquement au sixième plot de connexion conducteur ; et
lorsque le quatrième plot de connexion conducteur (004) connecté électriquement au premier composant électronique (121), et le deuxième plot de connexion conducteur (002) connecté électriquement au trou traversant (V1) sont formés sur la seconde surface (110b), le procédé comprend également : la formation, sur la seconde surface (110b), d'un septième plot de connexion conducteur connecté électriquement à la trace métallique.

13. Procédé de préparation selon l'une quelconque des revendications 8 à 12, dans lequel, après la formation d'une zone évidée (V2) dans la plaque de cadre (110), et avant le remplissage d'un espace de la zone évidée (V2) avec un matériau de remplissage (120), le procédé comprend également :
le placement d'un second composant électronique (122) dans la zone évidée (V2), dans lequel le second composant électronique (122) a un cinquième plot de connexion conducteur (005) ; et le fait d'amener une surface du cinquième plot de connexion conducteur (005) du second composant électronique (122) et une surface du premier plot de connexion conducteur (001) à être dans un même plan.
